(19) Europäisches Patentamt

European Patent Office

Office européen des brevets

(11) Publication number: **0 270 361 B1**

# EUROPEAN PATENT SPECIFICATION

(45) Date of publication of patent specification: **02.01.92** (51) Int. Cl.⁵: **H01S 3/19**, H01L 33/00

(21) Application number: **87310623.1**

(22) Date of filing: **02.12.87**

(54) **A method of producing a semiconductor laser.**

(30) Priority: **02.12.86 JP 288434/86**

(43) Date of publication of application:
**08.06.88 Bulletin 88/23**

(45) Publication of the grant of the patent:
**02.01.92 Bulletin 92/01**

(84) Designated Contracting States:
**DE FR NL**

(56) References cited:
**EP-A- 0 031 808**
**EP-A- 0 124 051**
**EP-A- 0 155 152**

**TECHNICAL DIGEST OF THE INTERNATIONAL ELECTRON DEVICES MEETING, Washington, D.C., 1st-4th December 1985, pages 646-649, IEEE, New York, US; Y. MIHASHI et al.: "A novel self-aligned AlGaAs laser with bent active layer grown by MOCVD"**

**PATENT ABSTRACTS OF JAPAN, vol. 10, no. 69 (E-389)[2126], 18th March 1986; & JP-A-60 217 689**

(73) Proprietor: **MITSUBISHI DENKI KABUSHIKI KAISHA**
2-3, Marunouchi 2-chome Chiyoda-ku
Tokyo 100(JP)

(72) Inventor: **Nagai, Yutaka Mitsubishi Denki Kabushiki Kaisha**
**LSI Kenkyusho No. 1, Mizuhara 4-chome**
**Itami-shi Hyogo-ken(JP)**
Inventor: **Mihasi, Yutaka Mitsubishi Denki Kabushiki Kaisha**
**LSI Kenkyusho No. 1, Mizuhara 4-chome**
**Itami-shi Hyogo-ken(JP)**
Inventor: **Yagi, Tetsuya Mitsubishi Denki Kabushiki Kaisha**
**Kitaitami Seisakusho No.1, Mizuhara**
**4-chome**
**Itami-shi Hyogo-ken(JP)**
Inventor: **Ota, Yoichiro Mitsubishi Denki Kabushiki Kaisha**
**Kitaitami Seisakusho No.1, Mizuhara**
**4-chome**
**Itami-shi Hyogo-ken(JP)**

(74) Representative: **Beresford, Keith Denis Lewis et al**
**BERESFORD & Co. 2-5 Warwick Court High Holborn**
**London WC1R 5DJ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to a method of producing a semiconductor laser, and more particularly to that enables obtaining a high reproducibility and high reliability semiconductor laser.

A prior art SBA laser is reported by Mihashi et al in a preprint of Associated Spring Meeting of Applied Physics Society related societies of 1985 30a-ZB-4.

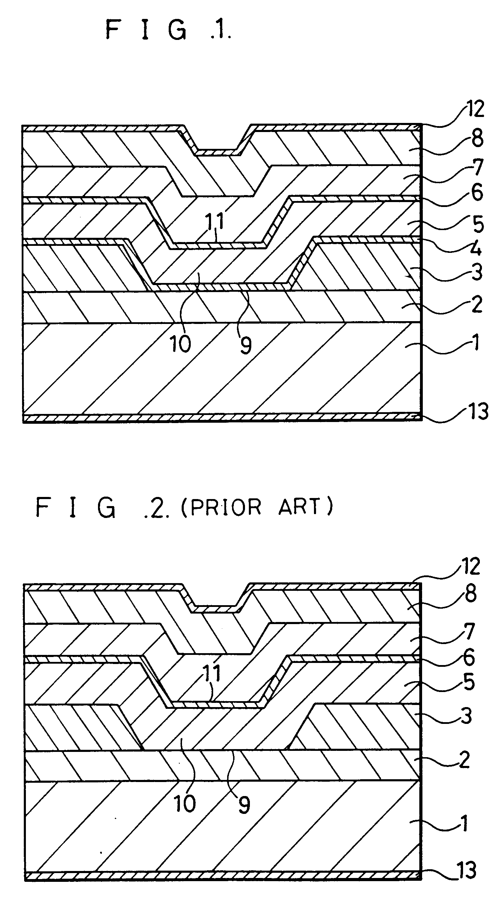

Figure 2 shows a cross-sectional view of an SBA (Self aligned laser with Bent Active layer) laser that is produced by utilizing MO-CVD method.

In this figure, the reference numeral 1 designates a p type GaAs substrate, the reference numeral 2 designates a buffer layer comprising p type $Al_{0.43}Ga_{0.57}As$, the reference numeral 3 designates a current blocking layer comprising n type GaAs, the reference numeral 5 designates a first cladding layer comprising p type $Al_{0.43}Ga_{0.57}As$, the reference numeral 6 designates an active layer comprising undoped $Al_{0.07}Ga_{0.93}As$, the reference numeral 7 designates a second cladding layer comprising n type $Al_{0.43}Ga_{0.57}As$, the reference numeral 8 designates a contact layer comprising n type GaAs, the reference numeral 9 designates an absorbed oxygen film, the reference numeral 10 designates a stripe groove which is produced in a reverse trapezoid cross section at the current blocking layer 3. The reference numeral 11 designates an active region, the reference numerals 12 and 13 designate an n electrode and a p electrode fixed to the contact layer 8 and the substrate 1, respectively.

The method of producing this SBA laser will be described briefly.

At first, a buffer layer 2 and a current blocking layer 3 are grown on the substrate 1 by MO-CVD method in a first crystal growth. After the growth, a stripe groove 10 having a reverse trapezoid cross section is produced at the current blocking layer 3 using an etchant for etching only GaAs selectively. As a result of this selective etching, the buffer layer 2 comprising p type $Al_{0.43}Ga_{0.57}As$ is exposed at the bottom of the strip groove. Next, in the second crystal growth using MO-CVD method a first cladding layer 5, an active layer 6, a second cladding layer 7, and a contact layer 8 are grown successively on the wafer having the strip groove 10. After the second crystal growth, an n type electrode 12 and a p type electrode 13 are produced on the contact layer 8 and at the surface of the substrate 1, respectively, by a method of such as vapor plating or spattering, thereby completing a SBA laser.

In this SBA laser, a current flows through the stripe groove 10 produced at the current blocking layer 3, and the portion parallel with the substrate 1 positioned above the stripe groove 10 of the active layer 6 becomes an active region 11. Furthermore, by using a MO-CVD method, the active layer 6 can be bent in a configuration close to that of the stripe groove 10. In this bent portion, there arises a refractive index difference in the transverse direction, and thus a light confinement in the transverse direction is conducted effectively, thereby resulting in a low threshold current and a high efficiency.

In this prior art method of producing a SBA laser, a buffer layer 2 comprising p type $Al_{0.43}Ga_{0.57}As$ is exposed at the bottom of the stripe groove 10 at the etching for producing the stripe groove 10. Meanwhile, as Al has a nature to be easily combined with oxygen, a thin oxide layer is produced at the surface of the buffer layer 2 by an etching or a water washing process. Further, it is exposed to the air until a second crystal growth is conducted, and oxidation proceeds with the passage of time. Generally such an oxide film is not a dense one, and almost all of it is dispersed during the subsequent temperature increases that follow with MOCVD growth processing. Occasionally quite a thin oxide layer can be retained or, even if such an oxide layer is not retained, an absorbed oxygen film 9 can result from a high concentration of oxygen that will combine with the aluminium.

Oxygen is taken into the crystal when a first cladding layer 5 comprising p type $Al_{0.43}Ga_{0.57}As$ is directly grown on the buffer layer 2, thereby producing a high resistance layer including oxygen which deteriorates the crystalinity. Such a reduction in crystalinity and production of a high resistance layer worsen the reproducibility of the laser characteristics as well as lead to deterioration in other characteristics such as by increasing threshold current and operational current. Furthermore, the temperature rising at operation is increased, thereby leading to a further deterioration of the element, and affecting an unfavourable influence on reliability.

The present invention is intended as a remedy.

According to the present invention as defined in claim 1, a stripe groove is produced by selectively etching the semiconductor layer obtained by the first crystal growth, a semiconductor layer including Al is exposed, and a semiconductor layer including Al is produced on the semiconductor layer including Al, after growth of a semiconductor layer including no Al, during a second crystal growth process. Subsequent oxidation of material grown at the bottom of the stripe groove is substantially avoided. The production of a high resistance layer having poor crystalinity in the second crystal growth is thus prevented, and a semiconductor laser superior in reproducibility and reliability is obtained.

Figure 1 is a diagram showing a cross-section of a semiconductor laser produced by a method embodying the present invention; and

Figure 2 is a diagram showing a cross-section of a prior art semiconductor laser.

An embodiment of the present invention will be described with reference to figure 1.

Figure 1 shows a semiconductor laser produced by a method embodying the present invention. In Figure 1, the same reference numerals designate the same elements as those shown in Figure 2. The reference numeral 4 designates a buffer layer comprising p type GaAs as a semiconductor layer including no Al.

Next, the production method will be described.

At first, in the first crystal growth a buffer layer 2 and a current blocking layer 3 are successively grown on a substrate 1. After the growth, a stripe groove 10 is produced by photolithography technique and an etching in a similar manner to that in the prior art method. Since the buffer layer 2 is exposed by this etching, an absorbed oxygen film 9 combined with Al is produced at the surface thereof. A buffer layer 4, a first cladding layer 5, an active layer 6, a second cladding layer 7, and a contact layer 8 are successively grown thereon in the second crystal growth. After the growth of these layers, an n type electrode 12 and a p type electrode 13 are produced on the contact layer 8 and at the surface of the substrate 1, respectively, by vapour plating or sputtering. The thickness of the buffer layer 4 is desirable to be larger than 0.01 μm and less than the depth of the stripe groove 10, that is, the thickness of the current blocking layer 3.

Also, in a similar manner to that in the prior art method, either a high concentration of oxygen is absorbed at the surface of the buffer layer 2 or an oxide film is produced thereon by etching or water washing during the production of the stripe groove 10. Furthermore, as the buffer layer 2 at the bottom of the groove is exposed to the outside air after the stripe groove 10 is produced, further oxygen is absorbed. A resulting absorbed oxygen film 9 is thus present at the start of the second crystal growth.

In the present embodiment, however, since a buffer layer 4 comprising p type GaAs is grown on the buffer layer 2 before growing a first cladding layer 5 comprising p type $Al_{0.43}Ga_{0.57}As$, the production of a high resistance layer at the surface of the crystal growth is suppressed. This is because the oxygen absorbed in the buffer layer 2 is less taken up by the crystal due to the fact that the buffer layer 4 does not include Al that is easily oxidised. This makes it possible to obtain a semiconductor laser having improved characteristics.

Al is described in the above-illustrated embodiment in which an SBA laser is employed. The present invention is applicable, for example, when an AlGaAs layer is regrown by the second crystal growth on the AlGaAs layer produced by the first crystal growth. This regrowing of layers over a GaAs buffer layer makes it possible to enhance the element characteristics easily.

## Claims

1. A method of producing a semiconductor laser comprising:

   a first crystal growth process producing on a substrate (1) a crystal growth layer (2,3) including semiconductor layers at least one of which includes aluminium;
   a process for producing a stripe groove (10) for the active region (11) by conducting a selective etching of said crystal growth layer to expose a portion of said semiconductor layer (2) including aluminium; and
   a second crystal growth process producing a semiconductor layer (4) including no aluminium on the entire wafer surface including the exposed surface of said semiconductor layer (2), further producing a semiconductor layer (5) including aluminium on said semiconductor layer (4) including no aluminium, and producing further layers (6,7,8) completing the semiconductor laser.

2. A method of producing a semiconductor laser as defined in claim 1, wherein: said substrate (1) comprises a first conductivity type GaAs; a buffer layer (2) comprising a first conductivity type $Al_xGa_{1-x}As$ and a current blocking layer (3) comprising a second conductivity type GaAs or $Al_yGa_{1-y}As$ are grown during said first crystal growth; and a buffer layer (4) comprising a first conductivity type GaAs, a first cladding layer (5) comprising a first conductivity type $Al_zGa_{1-z}As$, an active layer (6) comprising $Al_\alpha Ga_{1-\alpha}As$, a second cladding layer (7) comprising a second conductivity type $Al_\beta Ga_{1-\beta}As$, and a contact layer (8) comprising a second conductivity type GaAs are successively grown during said second crystal growth.

## Revendications

1. Un procédé de fabrication d'un laser à semiconducteurs, comprenant :
   une première étape de croissance cristalline produisant sur un substrat (1) une couche de croissance cristalline (2, 3) comprenant des couches de semiconducteurs dont l'une au moins contient de l'aluminium;

une étape destinée à produire un sillon en forme de ruban (10) pour la région active (11) par l'accomplissement d'une opération de gravure sélective de la couche de croissance cristalline, afin de mettre à nu une partie de la couche de semiconducteur (2) contenant de l'aluminium; et

une seconde étape de croissance cristalline, produisant une couche de semiconducteur (4) ne contenant pas d'aluminium, sur la totalité de la surface de la tranche, y compris la surface à nu de la couche de semiconducteur (2), produisant en outre une couche de semiconducteur (5) contenant de l'aluminium, sur la couche de semiconducteur (4) ne contenant pas d'aluminium, et produisant en outre des couches (6, 7, 8) qui achèvent la fabrication du laser à semiconducteurs.

2. Un procédé de fabrication d'un laser à semiconducteurs selon la revendication 1, dans lequel : le substrat (1) consiste en GaAs d'un premier type de conductivité; on fait croître pendant la première étape de croissance cristalline une couche tampon (2) consistant en $Al_xGa_{1-x}As$ d'un premier type de conductivité et une couche de blocage de courant (3) consistant en GaAs ou en $Al_yGa_{1-y}As$ d'un second type de conductivité; et on fait croître successivement pendant la seconde étape de croissance cristalline une couche tampon (4) consistant en GaAs du premier type de conductivité, une première couche de gaine (5) consistant en $Al_zGa_{1-z}As$ du premier type de conductivité, une couche active (6) consistant en $Al_\alpha Ga_{1-\alpha}As$, une seconde couche de gaine (7) consistant en $Al_\beta Ga_{1-\beta}As$ du second type de conductivité, et une couche de contact (8) consistant en GaAs du second type de conductivité.

**Patentansprüche**

1. Verfahren zum Herstellen eines Halbleiterlasers, mit:
   einem ersten Kristallwachstumsprozeß, bei dem auf einem Substrat (1) eine Kristallwachstumsschicht (2, 3) einschließlich Halbleiterschichten, von denen mindestens eine Aluminium enthält, erzeugt wird;
   einem Prozeß zum Erzeugen einer Streifenrille (10) für den aktiven Bereich (11) durch Ausführen eines selektiven Ätzens der Kristallwachstumsschicht zum Offenlegen eines Abschnittes der Aluminium enthaltenden Halbleiterschicht (2) und
   einem zweiten Kristallwachstumsprozeß, bei dem eine kein Aluminium enthaltende Halbleiterschicht (4) auf der gesamten Waferoberfläche einschließlich der offenliegenden Oberfläche der Halbleiterschicht (2) erzeugt wird, weiter Erzeugen einer Aluminium enthaltenden Halbleiterschicht (5) auf der kein Aluminium enthaltenden Halbleiterschicht (4) und Erzeugen weiterer Schichten (6, 7, 8), wodurch der Halbleiterlaser fertiggestellt wird.

2. Verfahren zum Herstellen eines Halbleiterlasers, wie er in Anspruch 1 definiert ist, bei dem: das Substrat (1) GaAs eines ersten Leitungstypes aufweist; eine Pufferschicht (2), die $Al_xGa_{1-x}As$ eines ersten Leitungstypes aufweist, und eine Stromsperrschicht (3), die GaAs oder $Al_yGa_{1-y}As$ eines zweiten Leitungstypes aufweist, während des ersten Kristallwachstums aufgewachsen werden und eine Pufferschicht (4), die GaAs eines ersten Leitungstypes, eine erste Plattierungsschicht (5), die $Al_zGa_{1-z}As$ eines ersten Leitungstypes aufweist, eine aktive Schicht (6), die $Al_\alpha Ga_{1-\alpha}As$ aufweist, eine zweite Plattierungsschicht (7), die $Al_\beta Ga_{1-\beta}As$ eines zweiten Leitungstypes aufweist, und eine Kontaktschicht (8), die GaAs eines zweiten Leitungstypes aufweist, aufeinanderfolgend während des zweiten Kristallwachstums aufgewachsen werden.

# F I G .1.

# F I G .2. (PRIOR ART)